Europäisches Patentamt

(19) European Patent Office

Office européen des brevets

(11) Publication number: **0 104 633**
**A2**

(12) **EUROPEAN PATENT APPLICATION**

(21) Application number: **83109528.6**

(22) Date of filing: **24.09.83**

(51) Int. Cl.³: **H 05 K 3/26**

(30) Priority: **28.09.82 US 426006**

(43) Date of publication of application:
**04.04.84 Bulletin 84/14**

(84) Designated Contracting States:
**DE FR GB NL**

(71) Applicant: **HONEYWELL INC.**
**Honeywell Plaza**
**Minneapolis Minnesota 55408(US)**

(72) Inventor: **Goepfert, Scott J.**
**963 Woodhill Drive**
**Roseville Minnesota 55113(US)**

(72) Inventor: **Wittmer, Gary G.**
**4980 Virginia Avenue North**
**New Hope Minnesota 55428(US)**

(72) Inventor: **Penzel, Wolfgang H.**
**7236 Ticonderoga Trail**
**Eden Prairie Minnesota 55344(US)**

(74) Representative: **Rentzsch, Heinz et al,**
**Honeywell Europe S.A. Holding KG Patent- und**
**Lizenzabteilung Kaiserleistrasse 55**
**D-6050 Offenbach am Main(DE)**

(54) **Method and apparatus for cleaning work pieces, in particular circuit boards.**

㊼ A method and apparatus for cleaning work pieces using halogen-free azeotropic cleaning liquids, preferably including alcohols chosen with the nature of the materials to be removed in mind. The pieces are first soaked in and then sprayed with the hot liquid, and then air dired, liquid from the spraying and drying processes being returned to the soaking container, which serves as a source for liquid to a still which in turn provides pure liquid for the spraying step.

FIG. 2

HONEYWELL INC.
Honeywell Plaza
Minneapolis, Minn.
USA

September 23, 1983
A2410102EP
HR/de

0104633

1

Method and apparatus for cleaning work pieces,
in particular circuit boards.

This invention relates primarily to the manufacture of electronic assemblies, and particularly to a system for cleaning residual flux from work pieces such as circuit boards after a soldering process has been completed.

## BACKGROUND OF THE INVENTION

Circuit boards have come to be of considerable importance in the manufacture of electronic equipment. A circuit board is typically a plate of insulating material carrying on one or more surfaces a pattern of conductive strips, and perforated so that the conductors of components such as resistors, capacitors, and the like mounted on a surface of the board may pass through the board and be soldered, as by wave soldering, to selected strips, whereby they interconnect the components in a desired circuit.

A good electrical connection is achieved by soldering only if the solder wets and forms a strong bond to the wire of the component and to the conductive strip. To insure and promote wetting of the wire and the strip, rosins and organic acids, called fluxes, are used to clean the metal on the surfaces at the time of soldering. The organic acids in a flux, and the residues remaining after soldering is completed, must be removed to insure the functionality of the board in the future, since these flux residues may cause an electrical failure on the board, by creating conductive short circuits, or by corroding a conductor until it breaks.

To eliminate wire corrosion and short circuits, circuit boards have been cleaned with a variety of chemical solutions, primarily halogenated solvents. Solvents included in this group are trichloroethylene, trichloroethane, and "Freon". These solvents remove some of the flux residue, but not always completely: often supplemental work is needed to get the work pieces satisfactorily cleaned. A recent issue is the proper disposal of used halogenated solvents, and their effects on the environment and atmosphere. Regulations greatly restrict their use, handling and disposal. Additionally, the level of permissable exposure for some halogenated cleaning solvents is reviewed, and more stringent exposure limits are expected in the near future.

As the halogenated solvents are being phased out of the industry, the trend in the electronics field is towards what is generally termed "aqueous" cleaners. These are water based materials that may contain soaps, detergents, wetting agents, and, most importantly, caustic neutralizers. These solutions are very alkaline. The water washes off the salt-like materials in the flux residue and the neutralizers attempt to saponify the oily components of the flux residue. These solutions present health problems by virtue of their caustic nature and are not reclaimable or recyclable. When the solution is exhausted, it must be neutralized and disposed of as a chemical waste: this also applies to the sludges that are formed.

Due to the alkaline nature of aqueous cleaning solutions, rigid quality controls must be maintained to assure thorough rinsing. Frequently, printed circuit assemblies are designed in such a manner that component density and arrangement allow for cleaning solution entrapment, which can only be corrected by redesign. The cleaning capability of aqueous cleaners is often greatly restricted by common circuit board assembly processes. Aluminum components, connectors, and fixtures show evidence of attack by the caustic solutions after repeated exposure. This corrosion of aluminum materials is a severe problem with aqueous cleaners.

## SUMMARY OF THE INVENTION

In order to overcome these problems the invention aims for an alternative to the above described cleaning process. This object is achieved by the cleaning method and apparatus as characterized in the claims. Briefly, the electronic component, board, or assembly, is conveyed into a cleaning station containing a hot halogen-free alcoholic azeotropic cleaning solvent thermostatically maintained at or near its boiling point. The work piece is moved slowly through the boiling solvent and then slowly passes from the cleaning station into a spraying station. At this point the piece is thoroughly sprayed, first with recirculated solvent from the cleaning station and then with freshly distilled cleaning solvent. Following the spray cleaning, the piece passes through a drying station including heated "air knives" where any solvent adherent to the work piece or the conveyor is removed, and the piece emerges clean and dry. The solvent used in the spraying operation is routed back to the cleaning station. A recovery still is connected to the cleaning station, and uses it as the source of contaminated solvent to be purified. The material cleaned from the boards accumulates in the still.

Various advantages and improvements which characterize the invention are pointed out with particularity in the subclaims.

- 3a -

A preferred embodiment will be described with reference
to the attached drawings, in which

    Fig. 1 is a block diagram of the cleaning system
        according to the invention;

    Fig. 2 is a mechanical diagram showing more details
        of a preferred embodiment of the invention;

    Fig. 3 is a fragmentary section of view along the
        line 3-3 of Fig. 2; and

    Fig. 4 is a block diagram showing liquid circulation
        in the apparatus.

## DESCRIPTION OF THE PREFERRED EMBODIMENT

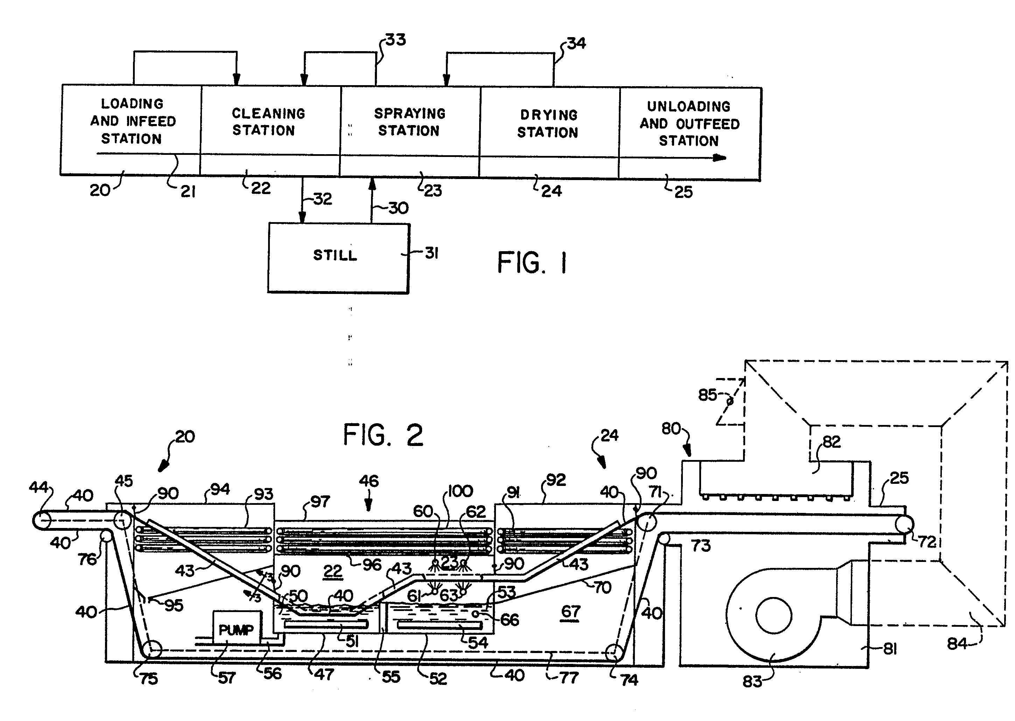

As shown in block diagram in FIGURE 1, work pieces to be cleaned are placed on a conveyor at a loading and infeed station 20 and are conducted by the conveyor, as indicated by the arrow 21, through a cleaning station 22, a spraying station 23, and a drying station 24, to an out-feed and conveyor unloading station 25 where the cleaned and dried pieces are removed from the conveyor.

Cleaning is accomplished by use of a halogen-free azeotropic cleaning liquid described below. The liquid, heated to or near its boiling temperature, is contained and circulated in a sump or reservoir in station 22, and the work pieces are moved into the liquid and soak in it as they move slowly to station 23. Here they are first subjected to cleaning sprays or jets of recirculated cleaning liquid, and then to rinsing sprays or jets of purified liquid of the same composition. The purified liquid is supplied at 30 as the condensed distillate of a steam heated still 31 which derives its input 32 from the reservoir of station 22. Station 23 also includes a second sump which overflows into station 22, as suggested at 33.

Drying station 24 may conveniently include an initial gravity drying component, draining at 34 into the sump of station 23, and a second component including a plurality of "air knives" or elongated nozzle structures extending across the path of the work pieces, through which air under pressure is supplied. The air removes from the work pieces any liquid residual thereon, and so dries the cleaned pieces.

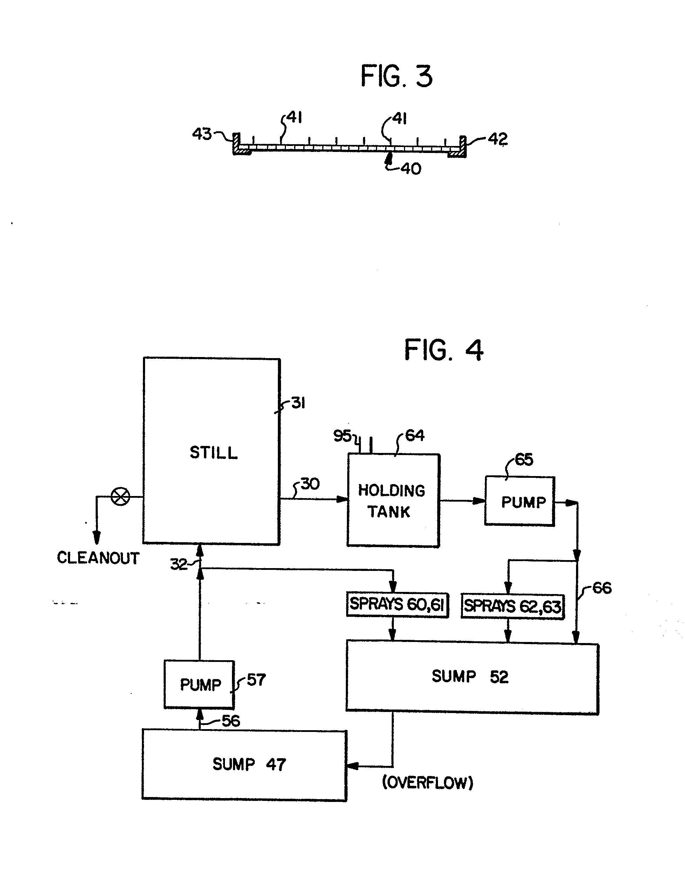

FIGURE 2 shows a mechanical structure of one embodiment of the cleaning system, in more detail. It includes stations 20, 22, 23, 24 and 25 assembled in a linear relation and traversed by a conveyor 40. The conveyor comprises an endless belt 61 cm wide, having a 2,54 cm mesh. Transverse rows of pins 41 (FIGURE 3) project outwardly from the belt at about 35,6 cm spacing. The pins are mutually spaced in the rows by about 3,81 cm and project approximately a 1,27 cm to engage the edges of circuit boards or other work pieces to be cleaned and convey them smoothly and without vibration through the apparatus.

Conveyor 40 has an upper, working run and a lower, return run. For the greater part of its working run the edges of the conveyor are supported on angle tracks 42 and 43, the tracks being broken away at certain central locations in FIGURE 2 to show more exactly the path of the conveyor itself.

In station 20 conveyor 40 passes horizontally over a pair of driven rollers 44 and 45, which engage the meshes of the screen. Then it enters tracks 42 and 43, which conduct it into a chamber 46 containing stations 22 and 23. Station 22 includes a sump 47 containing cleaning liquid 50, and a steam heater 51 for maintaining the liquid at its desired temperature. Station 23 includes a second sump 52 containing cleaning liquid 53, and having a steam heater 54. Sumps 47 and 52 have in common a dam 55 for overflow of liquid from sump 52 into sump 47, which has an outlet 56 connected to a pump 57.

As is clearly shown in FIGURE 2, tracks 42 and 43 lead conveyor 40 beneath the surface of the hot liquid 50 in sump 47. After passing slowly through that liquid, the tracks raise conveyor 40 over dam 55 and direct it horizontally between upper and lower cleaning sprays 60 and 61, which are above the surface of liquid 53 in station 23, and which discharge a liquid recirculated from sump 47 by pump 57. Next the conveyor passes between upper and lower rinsing sprays 62 and 63, also mounted above liquid 53. These sprays are fed with the output distillate 30 of still 31, as shown in FIGURE 4, where it is seen that the distillate is led to a holding tank 64 from which it is drawn by a pump 65 and supplied to sprays 62 and 63. The capacity of still 31 is chosen to be greater than the flow required for sprays 62 and 63, and the excess flow is supplied as a recirculant directly to sump 52 through an inlet 66. Still 33 is supplied with input liquid at 32 from pump 57.

After passing sprays 62 and 63, tracks 42 and 43 lead conveyor 40 into the gravity drying component 67 of station 24, where liquid entrained in or adherent to the conveyor and the work pieces thereon can drop off onto a slanting panel 70 which returns the liquid to sump 52, as indicated at 34 in FIGURE 1. The conveyor then passes over a driven roller 71 and proceeds horizontally to an idler roller 72 at station 25, the idle run of the conveyor being traced over idler roller 73, driven rollers 74 and 75, and idler roller 76 to station 20. The necessary slack in the conveyor required for it to remain on the tracks in its working run is assured by the fact that rollers 45 and 71 are synchronized by a drive 77, so that when appropriate slack is initially obtained, it will thereafter be maintained.

The second component of station 24 is shown at 80 to comprise a lower chamber 81 and an upper header 82 between which the working and return runs of conveyor 40 pass. Chamber 81 contains an exhaust fan 83 which draws air from the chamber, and delivers it through suitable ducting 84 indicated in broken lines to header 80. A plurality of elongated nozzles or "air knives" discharge air from header 82 against the conveyor and the work pieces thereon, removing any liquid remaining there so that dry clean pieces are available for discharge at station 25. Because the air recirculating in chamber 80 does pick up some vapor of cleaning liquid, a portion of the air determined by the setting of a damper 85 is discharged to the ambient atmosphere, through a recovery unit if this is desired.

Chamber 46 is in direct communication with the hot liquid in stations 22 and 23, and vapors therefrom do pass into stations 20 and 24. In order to prevent the noxious and flammable vapors from escaping into the work space surrounding the apparatus, two steps are taken. In the first place, a plurality of aprons 90 are provided, where the conveyor passes through chamber partitions, to substantially close the openings except when a work piece is passing there through. In the second place, coolant coils are provided to condense the vapors and return them to use. Thus a cooling coil 91 is provided under the cover 92 of component 67, to create a volume of low temperature air, and liquid condensed thereby falls to panel 70 and is returned to sump 52. A coolant coil 93 is provided under the cover 94 of station 20, and liquid condensed thereby is returned to holding tank 66 by a conduit 95. The principal source of vapor is the hot liquid in sumps 47 and 52, and chamber 46 containing these sumps has an inner cover 96 and an outer cover 97, between which there is positioned a further coolant coil 100. Liquid condensed by coil 100 is returned by gravity directly to the sumps.

An important feature of the invention is the nature of the cleaning liquid. The mixture should always be azeotropic, so that its composition does not change with repeated distillation, but the selection of liquids making up the mixture may advantageously be varied in accordance with the nature of the material to be cleaned from the work pieces. To remove very salt-laden residues, for example, a suitable azeotrope may be of de-ionized water and a three- or four- carbon alcohol, while oily or waxy residues may respond better to an azeotrope of de-ionized water and a six-carbon alcohol. For some purposes it may be desirable to use an azeotropic liquid containing more than one alcohol: mixtures of liquids other than alcohols and water may also be used, with the exception of halogenated materials.

By way of example the following azeotropic liquids are listed, together with their stable boiling points: (A) cyclohexane 74 parts, isopropyl alcohol, 18.5 parts, water 7.5 parts, boiling point 64.3°C; (B) acetonitrile 81 parts, methyl alcohol 19 parts, boiling point 63.5°C; (C) heptane 49 parts, methyl alcohol 51 parts, boiling point 59°C; (D) hexane 77 parts, isopropyl alcohol 23 parts, boiling point 62.7°C; (E) methyl alcohol 72 parts, octane 28 parts, boiling point 63°C; (F) ethyl alcohol 96 parts, water 4 parts, boiling point 78°C; (G) isopropyl alcohol 88 parts, deionized water, 12 parts, boiling point 82.5°C.

It is to be borne in mind that alcoholic azeotropes are all inflammable so that if an ignition source is present the mixture will flash and burn. Well known technology appropriate to handle these problems is to be incorporated into any apparatus for practicing the invention, and may include automatic component feed systems, ventilation controls, explosion proof motors and wiring, heat and smoke detectors, and carbon dioxide driven water based fire extinguishing foam apparatus.

## OPERATION

The operation of the cleaning apparatus will now be apparent. Still 31, pumps 57 and 65, fan 83, and conveyor drive 77 are put in operation, and the steam is supplied to heaters 51 and 54. When the cleaning liquid has reached its desired temperature, work pieces are placed on conveyor 40 at loading and infeed station 20, and are carried thereby to pass slowly through the hot liquid in sump 47, then to be washed by cleaning jets 60 and 61, and rinsed by jets 62 and 63. In moving through component 67 most of the liquid drops from the parts on the conveyor and in component 80 the remaining liquid is blown or vaporized off, so that a supply of clean, dry work pieces leave the apparatus at unloading station 25.

From the foregoing it will be evident that the invention comprises a method and apparatus for cleaning work pieces using halogen free azeotropic cleaning liquids, preferably alcohols chosen with the nature of the material to be removed in mind. The pieces are first soaked in and then sprayed and rinsed with the hot liquid, and then dried, the liquid from the spraying and drying processes being returned to the soaking container, which serves as a source for liquid to a still which in turn provides pure liquid for the rinsing step.

Claims:

1. A method of cleaning work pieces after soldering
   c h a r a c t e r i z e d   b y   the steps of
   a) immersing the work pieces for soaking in a
      azeotropic liquid solvent;
   b) spraying them with clean solvent; and
   c) blowing the residual solvent from the work
      pieces to dry them.

2. The method according to claim 1, c h a r a c t e r -
   i z e d   b y   the steps of
   a1) immersing the components for soaking in a hot
       halogen-free azeotropic liquid solvent;
   b1) spraying them with recirculated solvent;
   b2) rinsing them with clean solvent; and
   c1) blowing air across the work pieces to dry them.

3. The method according to claim 1 or 2,  c h a r a c -
   t e r i z e d   i n   t h a t   the liquid sprayed on
   the work pieces is then used for soaking the components.

4. The method according to claim 2 or 3,  c h a r a c -
   t e r i z e d   i n   t h a t   the clean solvent for
   rinsing is obtained by distilling a portion of the
   soaking liquid.

5. A cleaning system for carrying out the cleaning method
   according to one of the preceeding claims, c h a r a c -
   t e r i z e d   b y
   d) a cleaning station (22) containing an azeotropic
      cleaning liquid at substantially its boiling temperature;
   e) means (40) for conducting work pieces to be cleaned
      into,through, and out of said liquid, to soak therein;
   f) means (31,62,63) distilling liquid from said cleaning chamber and rinsing the work pieces with the distillate after emergence from said liquid;

g) means (81,82) blowing air over said work pieces to dry them; and

h) means (70) for returning the rinsing liquid to the cleaning station.

6. A cleaning system according to claim 5, c h a r a c -
t e r i z e d  b y

i) a spraying station (23);

j) a drying station (24);

k) means (33) returning liquid from said spraying station and said drying station to said cleaning station (22); and

l) means (31,30) distilling liquid from said cleaning chamber and supplying the distillate to sprays of said spraying station.

7. A cleaning solvent for performing the method according to one of claims 1 to 4, c h a r a c t e r i z e d
b y  an azeotropic mixture of liquids including at least one alcohol having between one and six carbon atoms.

8. A cleaning solvent according to claim 7, c h a r a c -
t e r i z e d  i n  t h a t  the mixture comprises approximately 88% of isopropyl alcohol and 12% of deionized water, by volume.

9. A cleaning solvent according to claim 7, c h a r a c -
t e r i z e d  i n  t h a t  the mixture contains approximately 74% of cyclohexane, 18.5 % isopropyl alcohol, and 7.5 % of water, by volume.

10. A cleaning solvent according to one of claim 7 to 9, c h a r a c t e r i z e d  i n  t h a t  the mixture of liquids is free from halogenated compounds.

FIG. 1

| LOADING AND INFEED STATION | CLEANING STATION | SPRAYING STATION | DRYING STATION | UNLOADING AND OUTFEED STATION |

STILL

FIG. 2

0104633

2/2

FIG. 3

43 41 41 42
40

FIG. 4

STILL 31

CLEANOUT

32

PUMP 57

56

SUMP 47

30 HOLDING TANK 64
95

PUMP 65

66

SPRAYS 60,61 SPRAYS 62,63

SUMP 52

(OVERFLOW)